(19) Europäisches Patentamt
European Patent Office
Office européen des brevets

(11) **EP 2 509 113 B1**

(12) **EUROPEAN PATENT SPECIFICATION**

(45) Date of publication and mention
of the grant of the patent:
**11.08.2021 Bulletin 2021/32**

(51) Int Cl.:
*H01L 31/042* ^(2014.01)     *H01G 9/20* ^(2006.01)

(21) Application number: **11846325.6**

(22) Date of filing: **23.05.2011**

(86) International application number:
**PCT/KR2011/003777**

(87) International publication number:
**WO 2012/077877 (14.06.2012 Gazette 2012/24)**

(54) **SELECTIVE LIGHT TRANSMISSIVE SOLAR BATTERY INCLUDING A LIGHT FILTERING UNIT**

SELEKTIV LICHTÜBERTRAGENDE SOLARBATTERIE MIT EINER LICHTFILTERUNGSEINHEIT

BATTERIE SOLAIRE TRANSMETTANT SÉLECTIVEMENT LA LUMIÈRE POURVUE D'UNE UNITÉ DE FILTRATION DE LA LUMIÈRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.12.2010 KR 20100125883**

(43) Date of publication of application:
**10.10.2012 Bulletin 2012/41**

(73) Proprietor: **Korea Institute Of Machinery & Materials**
**Yuseong-gu**
**Daejeon 305-343 (KR)**

(72) Inventors:
• **CHANG, Sung-Hwan**
  **Daejeon 305-739 (KR)**
• **KIM, Jae-Gu**
  **Daejeon 305-792 (KR)**
• **YOON, Jae-Sung**
  **Daejeon 305-343 (KR)**
• **JEON, Eun-Chae**
  **Anyang-si**
  **Gyeonggi-do 430-751 (KR)**
• **CHOI, Doo-Sun**
  **Daejeon 305-390 (KR)**
• **WHANG, Kyung-Hyun**
  **Seoul 135-280 (KR)**

(74) Representative: **Delorme, Nicolas et al**
**Cabinet Germain & Maureau**
**BP 6153**
**69466 Lyon Cedex 06 (FR)**

(56) References cited:
WO-A2-2010/059498     KR-A- 20100 072 856
KR-A- 20100 109 924   KR-A- 20100 119 886
US-A1- 2005 011 549   US-A1- 2007 017 568
US-A1- 2009 159 123   US-A1- 2009 308 380

• **None**

Description

## BACKGROUND OF THE INVENTION

### (a) Field of the Invention

The present invention a light selective transmission solar cell having a light filter. More particularly, the present invention relates to a light selective transmission solar cell having a light filter, and more particularly, to a light selective transmission solar cell having a light filter, which selectively transmits part of sunlight to use it for plant photosynthesis and uses the remaining sunlight as an energy source, thereby making effective use of a solar light source.

### (b) Description of the Related Art

Mankind has adopted fossil fuels as its primary source of energy because they are cheap and easy to use. However, fuel prices continues to rise due to a limited reserves compared to non-declining consumption levels, and even these reserves will soon run out. As a solution to the problem of energy depletion and the problem of carbon dioxide emissions, research on renewable energies, such as solar energy, wind power, is being actively pursued. Among these energies, solar cells, which are not much constrained by location, position, time, etc., are being spotlighted.

Particularly, dye-sensitized solar cells have high theoretical efficiency because they produce electricity by electrochemical principles, rather than by using p-type and n-type semiconductor junctions, and are made of an environment-friendly material. Therefore, they are receiving attention as a next-generation energy source.

Owing to the advantage of being environmentally friendly, there is a growing trend of using dye-sensitized solar cells in a place like a garden where plants are grown. They can be colored in various ways according to the dye used, and are therefore used for the purpose of improving the aesthetic appearance of a building, being attached to the ceiling in a botanical garden with ornamental plants.

However, such conventional dye-sensitized solar cells absorb sunlight in the entire wavelength range including wavelengths for plant growth in order to maximize optical absorption, thus inhibiting the growth of plants. Hence, there was difficulty in using the dye-sensitized solar cells for the entire surface of the ceiling in a place where the growth of plants is needed.

The above information disclosed in this Background section is only for enhancement of understanding of the background of the invention and therefore it may contain information that does not form the prior art that is already known in this country to a person of ordinary skill in the art.

## SUMMARY OF THE INVENTION

The present invention has been made in an effort to provide a light selective transmission solar cell having a light filter, which can selectively transmit a wavelength region required for plant photosynthesis and make use of the light energy not used for photosynthesis for electricity production.

The invention is defined by a light selective transmission solar cell according to claim 1.

The light selective transmission solar cell may further include an angle control part for controlling the angle of incidence of sunlight.

The light selective transmission solar cell may further include a refractive portion for refracting light above the upper electrode.

The refractive portion may have a prism-shaped pattern.

The refractive portion may have a prism-shaped pattern including a plurality of layers having furrows in different directions.

The refractive portion may have a plurality of tetrahedral patterns having vertexes protruding vertically upward from the upper substrate.

The light having passed through the refractive portion may enter the upper electrode at an angle of 1 ° to 35° with respect to an axis perpendicular to the upper electrode.

The lower electrode may have light transmissivity to transmit sunlight of a wavelength transmitted from the light absorption layer and transfer the same in a downward direction.

The dye may be a material for transmitting sunlight having a wavelength within a 400 to 500 nm range.

The dye may be a material for transmitting sunlight having a wavelength within a 600 to 700 nm range.

According to the present invention, there is provided a light selective transmission solar cell having a light filter, which can improve sunlight utilization by selectively transmitting only sunlight having a wavelength appropriate for photosynthesis and absorbing sunlight of other wavelengths for electricity production.

Moreover, the light filter reflects the sunlight not absorbed by the light absorption layer toward the light absorption layer, thereby further improving optical efficiency.

Furthermore, the refractive portion is used to refract light to enter the light filter within a predetermined range so as to improve light collection efficiency even when the solar altitude is low and vary the light having passed through the light filter within a wavelength range useful for photosynthesis.

## BRIEF DESCRIPTION OF THE DRAWINGS

FIG. 1 is a perspective view of a light selective transmission solar cell having a light filter according to a first exemplary embodiment of the present invention.

FIG. 2 is a schematic cross-sectional view of the light selective transmission solar cell having a light filter according to the first exemplary embodiment of the present invention.

FIG. 3 is a graph showing the absorption spectrum of chlorophyll a of a plant.

FIG. 4 is a graph showing the absorption spectrum of chlorophyll b of the plant.

FIG. 5 is a graph showing the action spectrum of the plant.

FIG. 6 is a graph showing the absorption of N719 dye.

FIG. 7 schematically illustrates a cross-section of the light selective transmission solar cell having a light filter of FIG. 1 when light is incident.

FIG. 8 schematically illustrates sunlight transmission in a horticultural facility with the light selective transmission solar cell having a light filter of FIG. 1 installed on the roof.

FIG. 9 is a perspective view and operation diagram of a light selective transmission solar cell having a light filter according to a second exemplary embodiment of the present invention.

FIG. 10 schematically illustrates sunlight transmission in a horticultural facility with the light selective transmission solar cell having a light filter of FIG. 9 installed on the roof.

FIG. 11 is a schematic cross-sectional view of a light selective transmission solar cell having a light filter according to a third exemplary embodiment of the present invention.

FIG. 12 schematically illustrates a refractive portion of the light selective transmission solar cell having a light filter of FIG. 11.

FIG. 13 illustrates the refraction of light incident on the refractive portion of FIG. 12.

FIG. 14 schematically illustrates a cross-section of the light selective transmission solar cell having a light filter of FIG. 11 when light is incident.

## DETAILED DESCRIPTION OF THE EMBODIMENTS

In several exemplary embodiments, constituent elements having the same configuration are representatively described in a first exemplary embodiment by using the same reference numeral and only constituent elements other than the constituent elements described in the first exemplary embodiment will be described in other embodiments.

Hereinafter, a light selective transmission solar cell 100 having a light filter according to a first exemplary embodiment of the present invention will be described in detail with reference to the accompanying drawings.

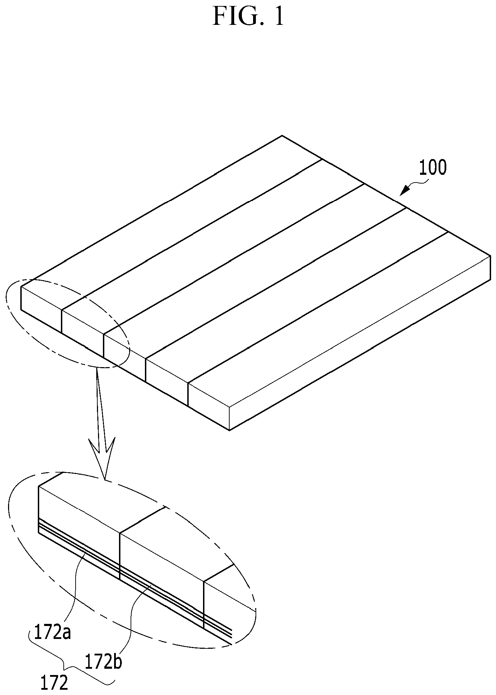

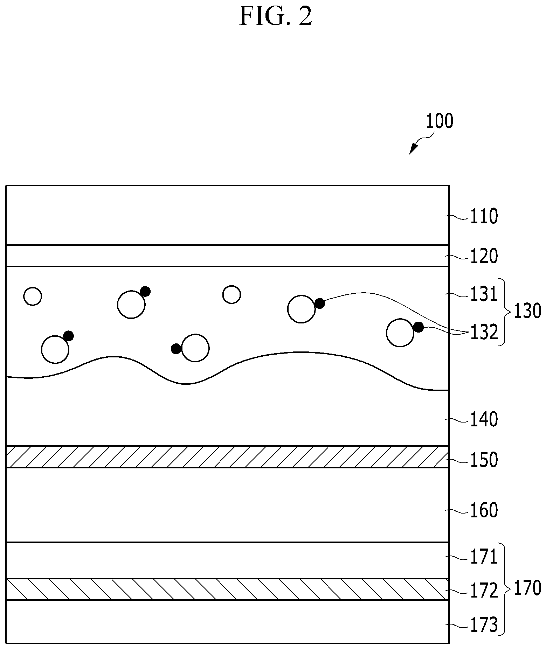

FIG. 1 is a perspective view of a light selective transmission solar cell having a light filter according to a first exemplary embodiment of the present invention. FIG. 2 is a schematic cross-sectional view of the light selective transmission solar cell having a light filter according to the first exemplary embodiment of the present invention.

Referring to FIGS. 1 and 2, the light selective transmission solar cell 100 having a light filter according to the first exemplary embodiment of the present invention includes an upper substrate 110, an upper electrode 120, a light absorption layer 130, an electrolyte 140, a lower electrode 150, a lower substrate 160, and a light filter 170.

The upper substrate 110 is provided in a flat plate shape, and formed of a light transmissive material to enable light to enter the light absorption layer 130 to be described later. The upper substrate 110 may be made of a material having high optical transmittance, including glass or a transparent resin substrate, such as polycarbonate, poly methyl methacrylate, and polyimide.

The upper electrode 120 is formed of any one of indium tin oxide (ITO), fluoro tin oxide (FTO), zinc oxide (ZnO), tin oxide ($SnO_2$), $ZnO$-$Ga_2O_3$, AND $ZnO$-$Al_2O_3$, and supports a porous membrane, which will be described later.

The light absorption layer 130 is a layer that selectively absorbs or transmits sunlight, and includes a porous membrane 131 and a dye 132.

The porous membrane 131 has minute and uniform pores, and includes semiconductor particulates having a very minute and uniform average particle size to have a larger surface area. In the present exemplary embodiment, the porous membrane 131 is formed of anatase-type titanium dioxide ($TiO_2$).

It is to be noted that the porous membrane 131 is not limited to the above-mentioned material but may be made of a metal oxide selected from the group consisting of titanium(Ti), zirconium (Zr), strontium (Sr), indium (In), lantan (La), molybdenum (Mo), tin (Sn), niob (Nb), magnesium (Mg), aluminum(Al), yttrium (Y), scandium (Sc), samarium (Sm), and gallium(Ga). The above-mentioned metal oxide may be one selected from the group consisting of tin oxide ($SnO_2$), zinc oxide (ZnO), and niobium oxide ($Nb_2O_5$).

The dye 132 is adapted to selectively absorb sunlight of a wavelength region inappropriate for photosynthesis, out of incident sunlight, and is adsorbed to a porous membrane.

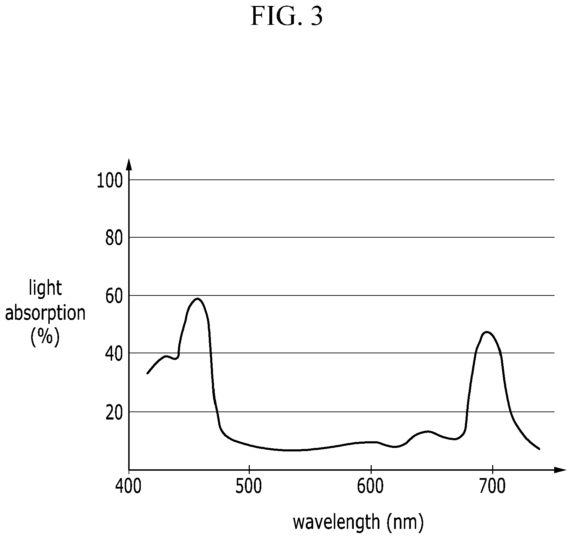

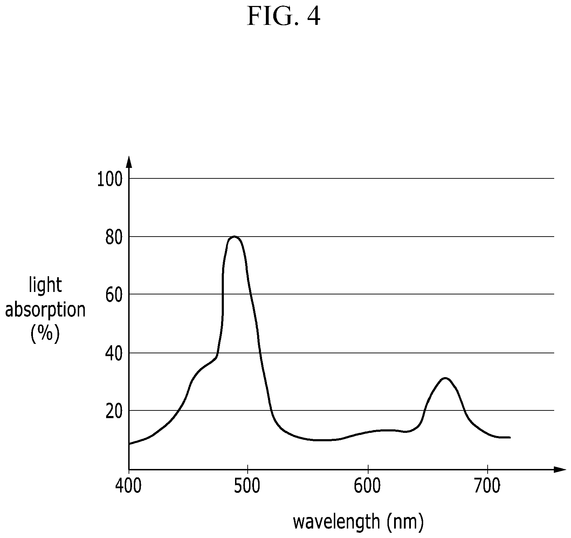

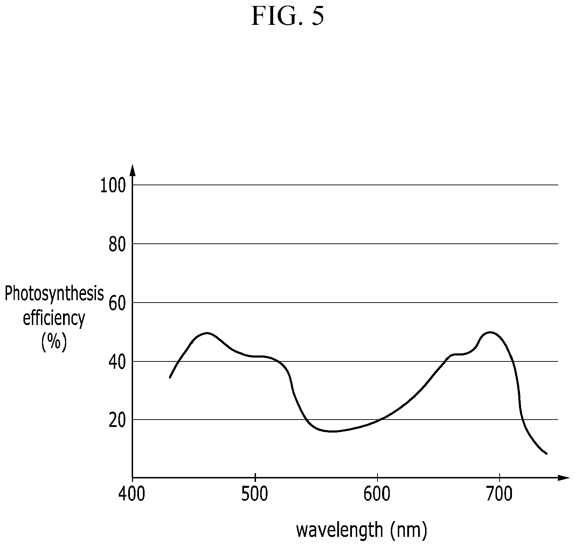

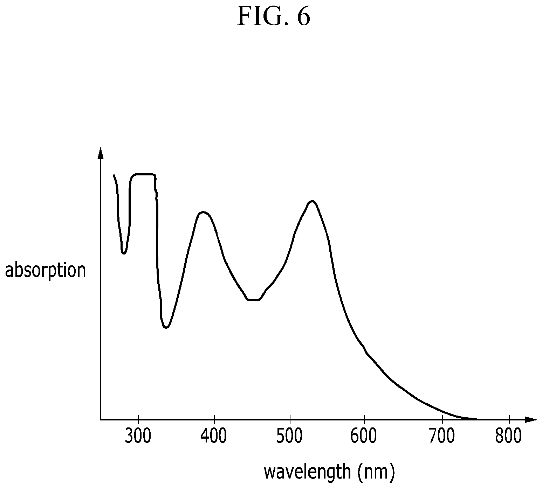

FIG. 3 is a graph showing the absorption spectrum of chlorophyll a of a plant. FIG. 4 is a graph showing the absorption spectrum of chlorophyll b of the plant. FIG. 5 is a graph showing the action spectrum of the plant. FIG. 6 is a graph showing the absorption of N719 dye.

Referring to FIG. 3 through FIG. 5, most plants absorb sunlight most actively at wavelengths in the ranges 400 nm to 500 nm and 600 nm to 700 nm for photosynthesis.

Accordingly, in order to transmit sunlight in a wavelength region of 600 nm to 700 nm in which most active absorption occurs during plant photosynthesis and cause the sunlight to enter a plant disposed below the light selective transmission solar cell having a light filter of this exemplary embodiment, a dye with any one of ruthenium (Ru) binding ligands -NCS, -CN, -CI, -Br, -I, and H2O attached thereon may be used.

Referring to FIG. 6, N719 dye has low optical absorption in a wavelength range of 600 nm or greater. In this exemplary embodiment, N719 dye is used as the dye 132. Also, by using N3 dye with red in it, sunlight having a wavelength region of 600 nm to 700 nm can be transmitted, and at the same time a solar cell colored in red can be implemented, thereby achieving aesthetic appearance.

Moreover, the dye 132 may be made of a material that transmits sunlight having a wavelength range of 400nm to 500 nm, which is a wavelength region required for plant photosynthesis.

The dye 132 does not have to be selected from the above-mentioned materials, but may be made of a mixture of a plurality of materials to selectively adjust the absorption of sunlight and the absorption wavelength region.

The electrolyte 140, an oxidation-reduction derivative, serves to continuously transfer electrons between the upper electrode 120 and the lower electrode 150 by reversible oxidation-reduction reactions, and are uniformly distributed in the form of liquid within the porous membrane in a space between the upper electrode 120 and the lower electrode 150.

In the present exemplary embodiment, the electrolyte 140 is a material which provides an oxidation-reduction pair, and may include any one of halogen metal iodides such as lithium iodide (LiI), sodium iodide (NaI), and potassium iodide (KI).

Preferably, sidewall surfaces between the upper electrode 120 and the lower electrode 150 to be described later are sealed to prevent the electrolyte 140 interposed therebtween from leaking out.

The lower electrode 50 is made of a material having a high transmittance in order to transmit sunlight having a wavelength not absorbed by the light absorption layer 130 in a downward direction, and is formed of any one of indium tin oxide (ITO), fluoro tin oxide (FTO), zinc oxide (ZnO), tin oxide ($SnO_2$), $ZnO-Ga_2O_3$, AND $ZnO-Al_2O_3$.

The lower substrate 160 is formed in a plate shape, and is made of a material having high optical transmittance, including glass or a transparent resin substrate, such as polycarbonate, poly methyl methacrylate, and polyimide.

The light filter 170 is a member that selectively reflects only sunlight in a wavelength region unintentionally transmitted by the light absorption layer 130 to the light absorption layer 130 to improve light absorption. The light filter 170 is provided in a flat plate shape under the lower substrate 160, and includes a combination of a pair of facing glass substrates 171 and 173 and a plurality of separated light transmission patterns 172 partitioned off disposed between a pair of separated light transmission disposed between the glass substrates 171 and 173. The dotted line illustrated in FIG. 1 is virtually laid out to surround an area including different types of light transmission patterns 172.

In the present invention, the light transmission patterns 172 include a first light transmission pattern 172a transmitting sunlight in a wavelength region of 400 nm to 500 nm and a second light transmission pattern 172a transmitting sunlight in a wavelength region of 600 nm to 700 nm. Interference filters that transmit light having a specific wavelength range and reflect other light, and have a light absorption of almost zero are used as the light transmission patterns 172a and 172b.

Sunlight of a wavelength region centered on $\lambda$ is transmitted by an interference filter having a thickness of $1/2$ $\lambda$. As such, in order to achieve high photosynthesis efficiency of plants, the thickness of the interference filter used as the first light transmission pattern 172a in in the invention is determined within a range of 200 to 250 nm to transmit sunlight of 400 to 500 nm, and the thickness of the interference filter used as the second light transmission pattern 172b is determined within a range of 300 to 350 nm to transmit sunlight of 600 to 700 nm.

While a general interference filter is formed of a plurality of thin films laminated on one another to filter only light of a specific wavelength region so that only a single color light with a specific wavelength is transmitted, the interference filter used as the light transmission pattern 172 in this exemplary embodiment is preferably formed of a single layer so that the transmission wavelength range is extended to a range in which photosynthesis efficiency is improved.

The interference filter of the present exemplary embodiment may be made of any one of titanium dioxide (TiO2), Zinc sulfide (ZnS), magnesium fluoride ($MgF_2$), cerium fluoride ($CeF_2$), and silicon dioxide ($SiO_2$)

As described above, the light filter of this exemplary embodiment includes a combination of the first light transmission pattern 172a and the second light transmission pattern 172b including interference filters having different thicknesses so as to sunlight of different wavelengths. In a modification, the light filter may include a single light transmission pattern to transmit light of a single wavelength, and the type and number of light transmission patterns are not limited if they exhibit optimal light efficiency.

From now on, the operation of the above-described light selective transmission solar cell 100 having a light filter according to the first exemplary embodiment will be described.

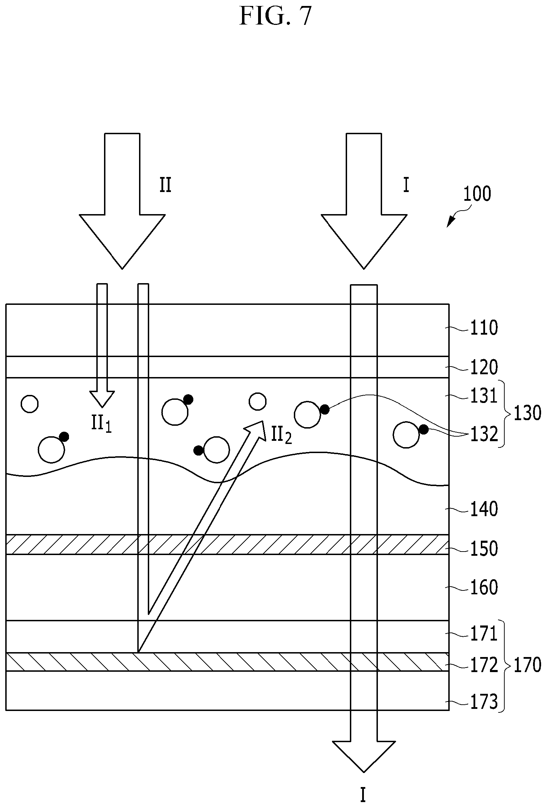

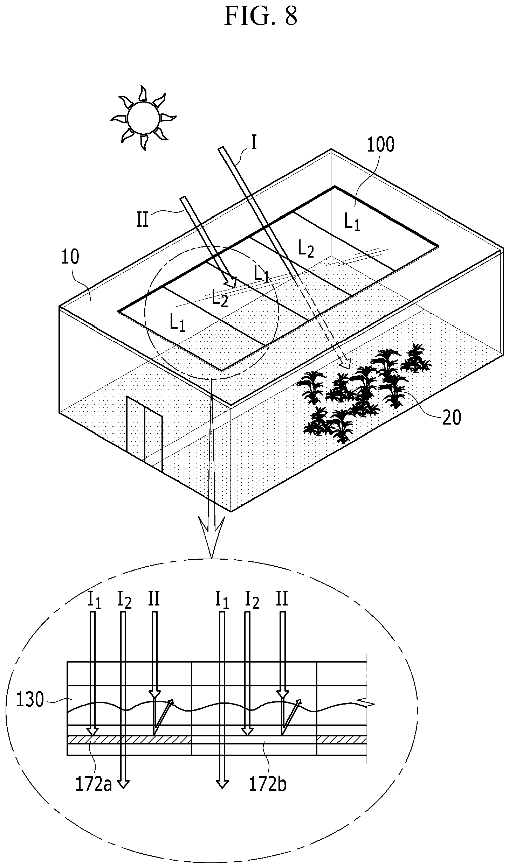

FIG. 7 schematically illustrates a cross-section of the light selective transmission solar cell having a light filter of FIG. 1 when light is incident. FIG. 8 schematically illustrates sunlight transmission in a horticultural facility with the light selective transmission solar cell having a light filter of FIG. 1 installed on the roof.

Referring to FIG. 7, sunlight I and II enters the light selective transmission solar cell having a light filter, passes through the upper substrate and upper electrode made of a light transmissive material and reaches the light absorption layer 130. At this point, photons of the sunlight optically excite molecules of the dye 132 by sufficient energy to put the dye 132 into an excited state. Electrons are injected from the dye 132 into titanium dioxide, which is the porous membrane 131, the electrons are moved from the porous membrane 131 to the top surface of the upper electrode 120 by scattering caused by electron density differences, and the electrons are moved again to the lower electrode 150 electrically connected to the upper electrode 120.

At the same time, the molecules of the dye 132, which lost electrons, are reduced unless they receive other electrons. These molecules of the dye 132 obtain electrons from I-electrons in the electrolyte, and the electrolyte that have provided the dye 132 with electrons are oxidized.

As $I_3$- of the oxidized electrolyte 140 is diffused and moved to the surface of the lower electrode 150 and receives the electrons moved from the upper electrode 120, $I_3$- is transformed into I-. By repeating the above-mentioned electron movement, electricity is produced.

The dye 132 of the light absorption layer 130 in the present exemplary embodiment may be any one or a combination of a dye for transmitting sunlight in a wavelength range of 600 to 700 nm in a downward direction and a dye having high transmittance of sunlight in a wavelength region of 400 to 500 nm.

That is, the first sunlight I in a wavelength region of 400 to 500 nm or 600 to 700 nm appropriate for photosynthesis passes through the light absorption layer 130 and an optical controller 170 and is transmitted downward, most $II_1$ of the second sunlight II is absorbed by the light absorption layer 130 in the above-described order and becomes a source of electric power, and the sunlight $II_2$ transmitted through the light absorption layer 130 without being absorbed is reflected and re-absorbed in the light absorption layer 130 by means of the light transmission pattern 172 of the optical controller 170, whereby electric power production efficiency can be improved.

Referring to FIG. 8, the operation of the light selective transmission solar cell 100 having a light filter of the present exemplary embodiment will be explained by taking an example in which it is installed to be used as part of the roof in the horticultural facility 10 and produces electricity.

An area in which the first light transmission pattern 172a for transmitting only sunlight in a 400 to 500 nm wavelength region is denoted by $L_1$, an area in which the second light transmission pattern 172b for transmitting only sunlight in a 600 to 700 nm wavelength region is denoted by $L_2$, the sunlight in the 400 to 500 nm wavelength region is denoted by $I_2$, the sunlight in the 600 to 700 nm wavelength region is denoted by $I_1$, and sunlight in other wavelength regions is defined as II.

When sunlight inappropriate for photosynthesis, namely, the sunlight II of a wavelength region that needs to be used as an electric power source in the light absorption layer 130 fails to reach the light absorption layer 130 but reaches the light transmission patterns 172a and 172b, the light transmission patterns 172a and 172b reflect the sunlight II to use it as an electric power source.

When the sunlight $I_1$ and $I_2$ reaches the area $L_1$, only $I_2$ passes through the light transmission pattern 172a and reaches the plant 20 below it.

When the sunlight $I_1$ and $I_2$ reaches the area $L_2$, it passes through the light absorption layer 130 but only $I_1$ passes through the light transmission pattern 172b and reaches the plant 20 below it.

In other words, according to the light selective transmission solar cell 100 having a light filter of the present exemplary embodiment, only sunlight in a wavelength range appropriate for plant photosynthesis is filtered and provided to the plant 20 set out inside the horticultural facility 10. That is, sunlight of a wavelength region unnecessarily transmitted through the light absorption layer 130 is filtered by the light transmission filters 172a and 172b and repeatedly provided to the light absorption layer 130, thereby improving electricity production.

Next, a light selective transmission solar cell 200 having a light filter according to a second exemplary embodiment of the present invention will be described.

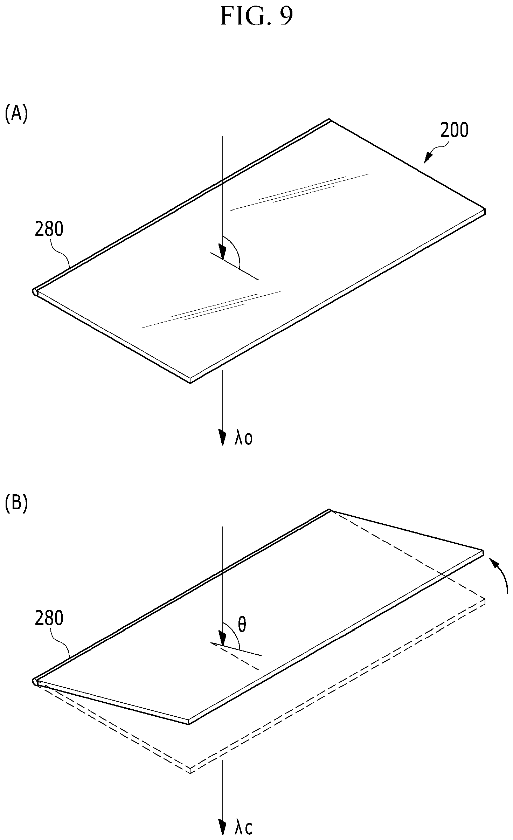

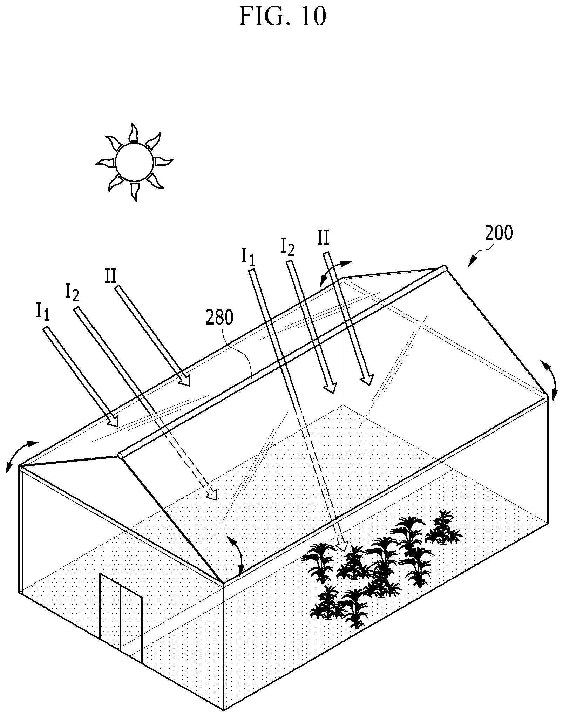

FIG. 9 is a perspective view and operation diagram of a light selective transmission solar cell 200 having a light filter according to a second exemplary embodiment of the present invention. FIG. 10 schematically illustrates sunlight transmission in a horticultural facility with the light selective transmission solar cell having a light filter of FIG. 9 installed on the roof.

The light selective transmission solar cell 200 having a light filter according to the second exemplary embodiment of the present invention includes an upper substrate, an upper electrode, a light absorption layer, an electrolyte, a lower electrode, a lower substrate, a light filter, and an angle control part 280. The light absorption layer, electrolyte, lower electrode, lower substrate, and light filter are identical to the corresponding components of the first exemplary embodiment, except for the angle control part 280, so redundant explanation thereof will be omitted.

Referring to FIG. 9, the angle control part 280 is a member that controls the angle of incident sunlight, and is preferably a predetermined driving member, such as a rotary motor, to control the angle between the incident sunlight and the top surface of the light selective transmission solar cell 200 having a light filter of this exemplary embodiment.

## (Equation 1)

$$\lambda_c = \lambda_0 \sqrt{1 - \frac{\sin^2\theta}{n^{*2}}}$$

(wherein $\lambda_c$ is the center wavelength of light, $\lambda_0$ is the center wavelength of light that is changed by an interference filter, $\theta$ is the angle of incidence of light, and n* is the effective refractive index of the filter)

Equation 1 is an equation describing the relationship between the angle ($\theta$) of incidence of light into the interference filter and the center wavelength $\lambda$ c of light after transmission. That is, the wavelength band of light transmitted by the light selective transmission solar cell 200 having a light filter of this exemplary embodiment can be easily controlled by controlling the angle of incidence of sunlight by using the angle control part 280 of this exemplary embodiment.

Moreover, light efficiency can be improved by controlling the angle of incidence depending on solar altitude, which varies with time and season.

While the present exemplary embodiment uses a light selective transmission solar cell having a light filter with a single plane, a modification shown in FIG. 10 provides a light selective transmission solar cell having a pair of light filters, which is disposed neighboring the angle control part 280 at the center, and controls the angle of incidence of sunlight so that the sunlight $I_2$ in a 400 to 500 nm wavelength region is transmitted through one plane and the sunlight $I_1$ in a 600 to 700 nm wavelength region is transmitted through the other plane.

Next, a light selective transmission solar cell having a light filter according to a third exemplary embodiment of the present invention will be described.

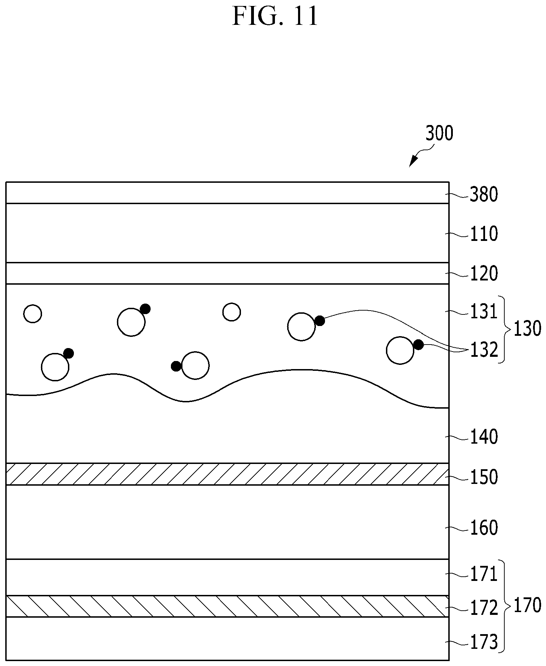

FIG. 11 is a schematic cross-sectional view of a light selective transmission solar cell having a light filter according to a third exemplary embodiment of the present invention. Referring to FIG. 11, the light selective transmission solar cell having a light filter according to the third exemplary embodiment of the present invention includes a refractive portion 380, an upper substrate 110, an upper electrode 120, a light absorption layer 130, an electrolyte 140, a lower electrode 150, a lower substrate 160, and a light filter 170.

The upper substrate 110, upper electrode 120, light absorption layer 130, electrolyte 140, lower electrode 150, lower substrate 160, and light filter 170 are identical to the corresponding components of the first exemplary embodiment, so redundant explanation thereof will be omitted.

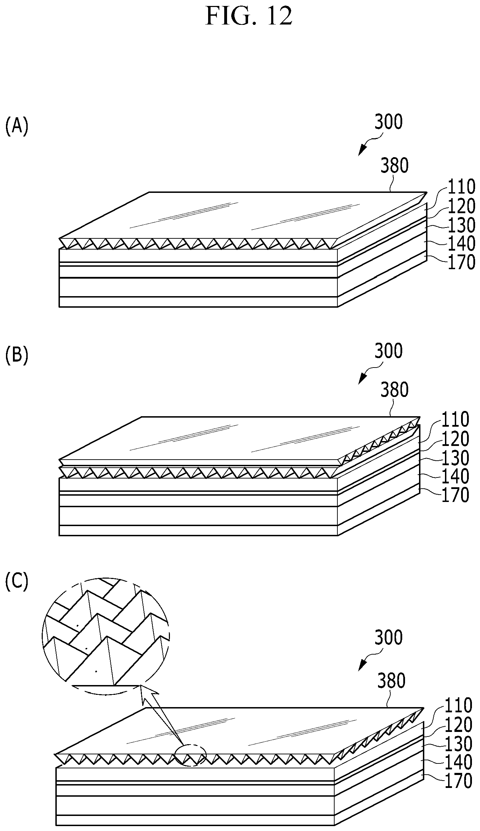

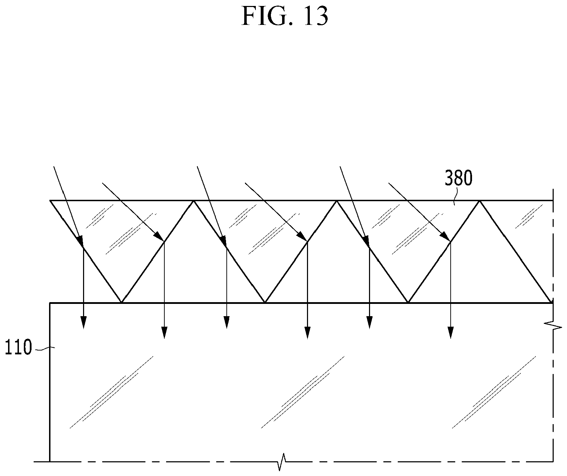

FIG. 12 schematically illustrates a refractive portion of the light selective transmission solar cell having a light filter of FIG. 11. FIG. 13 illustrates the refraction of light incident on the refractive portion of FIG. 12.

Referring to FIG. 11 and FIG. 12(a), the refractive portion 380 is a member for refracting incident light, and includes a combination of a plurality of prism-shaped patterns which have a triangular cross-section and are longitudinally formed over the upper substrate 110. Referring to FIG. 13, using the refractive portion 380 causes the light having passed through the prism-shaped refractive portion 380 to be refracted and perpendicularly enter the upper substrate 100.

Although the prism shape of the refractive portion 380 may formed in a single layer, a prism shape according to a modification may have a double-layer configuration by forming a prism-shaped pattern having furrows perpendicular to each other in different layers, as shown in FIG. 12(b). According to the modification, the entire refractive index can be improved by refracting light with respect to different axial components in each layer.

In another modification, referring to FIG. 12(c), the refractive portion 380 may be configured to have a plurality of tetrahedral patterns having vertexes protruding vertically upward from the upper substrate.

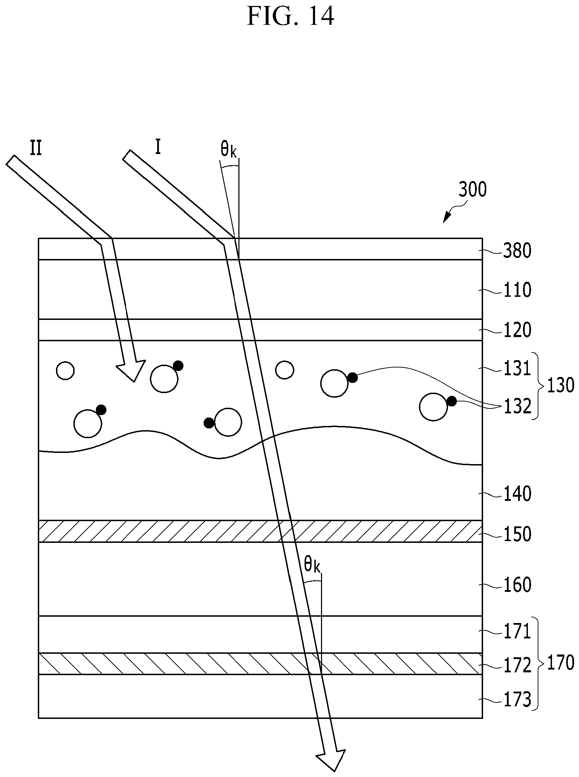

FIG. 14 schematically illustrates a cross-section of the light selective transmission solar cell having a light filter of FIG. 11 when light is incident.

Referring to FIG. 14, according to a light selective transmission solar cell 300 having a light filter of the present exemplary embodiment, light having passed through the refractive portion 380 disposed on the top is refracted at a predetermined angle and transferred to the light absorption layer 130 and light filter 170 disposed below the refractive portion 380.

The light having passed through the refractive portion 380 travels in the same manner as the light having passed through the light selective transmission solar cell according to the first exemplary embodiment. That is, part II of the refractive light is absorbed by the light absorption layer 130 to produce electricity, and the light I of wavelength regions of 300 to 400 nm and 600 to 700 nm passes through the light filter 170. At this point, referring to Equation 1, wavelength changes with the angle $\theta_k$ of incidence of the light I into the light filter 170.

Meanwhile, in the case that light does not vertically enter the upper substrate depending on the shape and number of prism patterns, even with the use of the refractive portion 380, this exemplary embodiment may present an allowable range of the angle $\theta_k$ of incidence into the upper substrate 110 by refraction on the refractive portion 170, i.e., of the angle $\theta_k$ of incidence into the light filter 170.

Since the wavelength range of the light I is changed by the light filter 170, light having a wavelength of 650 nm, an intermediate value between 600 nm and 700 nm, may vary with an upper limit at the same 650 nm wavelength after passing through the flight filter 170, and the light having the wavelength of 650nm varies with a lower limit at the 600 nm wavelength required for plant photosynthesis. Thereby, the range of the angle ($\theta_k$) of incidence of the light refracted by the refractive portion 380 into the light filter 170 may be determined as in the following Equation 2.

(Equation 2)

$$600 \leq \lambda_c = \lambda_0 \sqrt{1 - \frac{\sin^2 \theta_k}{n^{*2}}} \leq 650$$

wherein $\lambda_0$ is 650nm, and n*= is 1.5. Thus, the range of the angle ($\theta_k$) of incidence of the light refracted by the refractive portion 380 into the light filter 170 may be presented as follows.

(Equation 3)

$$0° \leq \theta_k \leq 35.23°$$

That is, in the case that the refractive portion 380 is controlled such that light enters the light filter 170 within the range of 0° to 35° as shown in Equation 3, the light in the 650 nm wavelength passing through the light filter 170 may vary within a 600 to 650 nm range, which is efficient for photosynthesis, and be provided to the plant disposed on the bottom.

Meanwhile, within the range of the angle of incidence as shown in FIG. 3, a wavelength of 450 nm, which is an intermediate value between 400 nm and 500 nm, also varies within the range of 415 to 450 nm corresponding to a wavelength exhibiting high photosynthesis efficiency, and is provided to the plant disposed on the bottom.

Accordingly, according to the present exemplary embodiment, light entering the light filter 170 is refracted such that it has an angle of incidence within the range of 0° to 35. Therefore, light collection efficiency can be enhanced even when the solar altitude is low, and the light having passed through the light filter 170 can vary within a wavelength range useful for photosynthesis.

The scope of the present invention is not limited to the above-described exemplary embodiment, but may be carried out in various embodiments within the scope of the appended claims.

**<Description of symbols>**

100 : light selective transmission solar cell having light filter according to first exemplary embodiment of present invention
120 : upper electrode 140 : electrolyte
130 : light absorption layer 150 : lower electrode
131 : porous membrane 170 : light filter

132 : dye

**Claims**

1. (Currently Amended) A light selective transmission solar cell (100, 200) having a light filter comprising:

   an electrode portion consisting of an upper electrode (120) and a lower electrode (150) disposed to face the upper electrode (120);
   a light absorption layer (130) disposed between the upper electrode (120) and the lower electrode (150), and comprising a dye (132) for transmitting light of a certain wavelength of incident sunlight; and
   a light filter (170) disposed below the lower electrode (150), and transmitting light of a certain wavelength of the light transmitted through the light absorption layer (130) and reflecting light of a certain wavelength to the light absorption layer (130),
   **characterized in that**
   the light filter comprises a plurality of light transmission patterns (172) for selectively transmitting light corresponding to different wavelength ranges, and
   the light transmission patterns (172) include a first light transmission pattern (172a) transmitting sunlight in a wavelength region of 400 nm to 500 nm and a second light transmission pattern (172b) transmitting sunlight in a wavelength region of 600 nm to 700 nm, and
   the first light transmission pattern (172a) and the second light transmission pattern (172b) include interference filters having a light absorption of almost zero, the thickness of the interference filter used as the first light transmission pattern (172a) is determined within a range of 200 to 250 nm to transmit sunlight of 400 to 500 nm, and the thickness of the interference filter used as the second light transmission pattern (172b) is determined within a range of 300 to 350 nm to transmit sunlight of 600 to 700 nm.

2. The light selective transmission solar cell of claim 1, further comprising an angle control part (280) for controlling the angle of incidence of sunlight.

3. The light selective transmission solar cell (100, 200) of claim 1, further comprising a refractive portion (380) for refracting light above the upper electrode (120).

4. The light selective transmission solar cell (100, 200) of claim 3, wherein the refractive portion (380) has a prism-shaped pattern.

5. The light selective transmission solar cell (100, 200) of claim 3, wherein the refractive portion (380) has a prism-shaped pattern comprising a plurality of layers having furrows in different directions.

6. The light selective transmission solar cell (100, 200) of claim 3, wherein the refractive portion (380) has a plurality of tetrahedral patterns having vertexes protruding vertically upward from the upper substrate (110).

7. The light selective transmission solar cell (100, 200) of claim 3, wherein the light having passed through the refractive portion (380) enters the upper electrode (120) at an angle of 1° to 35° with respect to an axis perpendicular to the upper electrode (120).

8. The light selective transmission solar cell (100, 200) of claim 1, wherein the lower electrode (150) has light transmissivity to transmit sunlight of a wavelength transmitted from the light absorption layer (130) and transfer the same in a downward direction.

9. The light selective transmission solar cell (100, 200) of claim 1, wherein the dye (132) is a material for transmitting sunlight having a wavelength within a 400 to 500 nm range.

10. The light selective transmission solar cell (100, 200) of claim 1, wherein the dye (132) is a material for transmitting sunlight having a wavelength within a 600 to 700 nm range.

**Patentansprüche**

1. Solarzelle (100, 200) mit selektivem Lichtdurchlass, die einen Lichtfilter aufweist, umfassend:

   einen Elektrodenabschnitt, der aus einer oberen Elektrode (120) und einer unteren Elektrode (150) besteht, welche so angeordnet ist, dass sie der oberen Elektrode (120) zugewandt ist;
   eine Lichtabsorptionsschicht (130), die zwischen der oberen Elektrode (120) und der unteren Elektrode (150) angeordnet ist und einen Farbstoff (132) umfasst, um Licht einer bestimmten Wellenlänge aus einfallendem Sonnenlicht durchzulassen; und
   einen Lichtfilter (170), der unter der unteren Elektrode (150) angeordnet ist und Licht einer bestimmten Wellenlänge aus dem durch die Lichtabsorptionsschicht (130) durchgelassenen Licht durchlässt, und Licht einer bestimmten Wellenlänge zur Lichtabsorptionsschicht (130) reflektiert,
   **dadurch gekennzeichnet, dass**
   der Lichtfilter eine Vielzahl von Lichtdurchlassmustern (172) zum selektiven Durchlassen von Licht, das verschiedenen Wellenlängenbereichen entspricht, umfasst, und
   die Lichtdurchlassmuster (172) ein erstes Lichtdurchlassmuster (172a), das Sonnenlicht in einer Wellenlängenregion von 400 nm bis 500 nm durchlässt, und ein zweites Lichtdurchlassmuster (172b) einschließen, das Sonnenlicht in einer Wellenlängenregion von 600 nm bis 700 nm durchlässt, und
   das erste Lichtdurchlassmuster (172a) und das zweite Lichtdurchlassmuster (172b) Interferenzfilter einschließen, die eine Lichtabsorption von nahezu Null aufweisen, wobei die Dicke des Interferenzfilters, der als das erste Lichtdurchlassmuster (172a) verwendet wird, auf innerhalb eines Bereichs von 200 bis 250 nm festgelegt ist, um Sonnenlicht von 400 bis 500 nm durchzulassen, und die Dicke des Interferenzfilters, der als das zweite Lichtdurchlassmuster (172b) verwendet wird, auf innerhalb eines Bereichs von 300 bis 350 nm festgelegt ist, um Sonnenlicht von 600 bis 700 nm durchzulassen.

2. Solarzelle mit selektivem Lichtdurchlass nach Anspruch 1, weiter einen Winkelsteuerteil (280) umfassend, um den Einfallswinkel von Sonnenlicht zu steuern.

3. Solarzelle (100, 200) mit selektivem Lichtdurchlass nach Anspruch 1, weiter einen lichtbrechenden Abschnitt (380) umfassend, um Licht oberhalb der oberen Elektrode (120) zu brechen.

4. Solarzelle (100, 200) mit selektivem Lichtdurchlass nach Anspruch 3, wobei der lichtbrechende Abschnitt (380) ein prismaförmiges Muster aufweist.

5. Solarzelle (100, 200) mit selektivem Lichtdurchlass nach Anspruch 3, wobei der lichtbrechende Abschnitt (380) ein prismaförmiges Muster aufweist, das eine Vielzahl von Schichten mit Furchen in verschiedenen Richtungen aufweist.

6. Solarzelle (100, 200) mit selektivem Lichtdurchlass nach Anspruch 3, wobei der lichtbrechende Abschnitt (380) eine Vielzahl von tetraedrischen Mustern mit Ecken aufweist, die vom oberen Substrat (110) vertikal nach oben ragen.

7. Solarzelle (100, 200) mit selektivem Lichtdurchlass nach Anspruch 3, wobei das Licht, das durch den lichtbrechenden Abschnitt (380) getreten ist, in Bezug auf eine zur oberen Elektrode (120) senkrecht stehende Achse in einem Winkel von 1° bis 35° in die obere Elektrode (120) eintritt.

8. Solarzelle (100, 200) mit selektivem Lichtdurchlass nach Anspruch 1, wobei die untere Elektrode (150) Lichtdurchlässigkeit aufweist, um Sonnenlicht mit einer Wellenlänge, das von der Lichtabsorptionsschicht (130) durchgelassen wurde, durchzulassen und es in eine Abwärtsrichtung zu übertragen.

9. Solarzelle (100, 200) mit selektivem Lichtdurchlass nach Anspruch 1, wobei es sich bei dem Farbstoff (132) um ein Material handelt, um Sonnenlicht mit einer Wellenlänge innerhalb eines Bereichs von 400 bis 500 nm durchzulassen.

10. Solarzelle (100, 200) mit selektivem Lichtdurchlass nach Anspruch 1, wobei es sich bei dem Farbstoff (132) um ein Material handelt, um Sonnenlicht mit einer Wellenlänge innerhalb eines Bereichs von 600 bis 700 nm durchzulassen.

**Revendications**

1. Cellule solaire à transmission sélective de la lumière (100, 200) ayant un filtre de lumière comprenant :

une partie d'électrode constituée d'une électrode supérieure (120) et d'une électrode inférieure (150) disposée de manière à faire face à l'électrode supérieure (120) ;

une couche d'absorption de lumière (130) disposée entre l'électrode supérieure (120) et l'électrode inférieure (150), et comprenant un colorant (132) pour transmettre la lumière d'une certaine longueur d'onde de la lumière du soleil incidente ; et

un filtre de lumière (170) disposé en dessous de l'électrode inférieure (150), et transmettant la lumière d'une certaine longueur d'onde de la lumière transmise à travers la couche d'absorption de lumière (130) et réfléchissant la lumière d'une certaine longueur d'onde vers la couche d'absorption de lumière (130),

**caractérisée en ce que**

le filtre de lumière comprend une pluralité de motifs de transmission de lumière (172) pour transmettre sélectivement la lumière correspondant à différentes plages de longueurs d'onde, et

les motifs de transmission de lumière (172) comportent un premier motif de transmission de lumière (172a) transmettant la lumière du soleil dans une région de longueur d'onde allant de 400 nm à 500 nm et un deuxième motif de transmission de lumière (172b) transmettant la lumière du soleil dans une région de longueur d'onde allant de 600 nm à 700 nm, et

le premier motif de transmission de lumière (172a) et le deuxième motif de transmission de lumière (172b) comportent des filtres d'interférence ayant une absorption de lumière presque nulle, l'épaisseur du filtre d'interférence utilisé comme étant le premier motif de transmission de lumière (172a) est déterminée dans une plage allant de 200 à 250 nm pour transmettre la lumière du soleil de 400 à 500 nm, et l'épaisseur du filtre d'interférence utilisé comme étant le deuxième motif de transmission de lumière (172b) est déterminée dans une plage allant de 300 à 350 nm pour transmettre la lumière du soleil de 600 à 700 nm.

2.  Cellule solaire à transmission sélective de la lumière de la revendication 1, comprenant en outre une partie de régulation d'angle (280) pour réguler l'angle d'incidence de la lumière du soleil.

3.  Cellule solaire à transmission sélective de la lumière (100, 200) de la revendication 1, comprenant en outre une partie réfractive (380) pour réfracter la lumière au-dessus de l'électrode supérieure (120).

4.  Cellule solaire à transmission sélective de la lumière (100, 200) de la revendication 3, dans laquelle la partie réfractive (380) a un motif en forme de prisme.

5.  Cellule solaire à transmission sélective de la lumière (100, 200) de la revendication 3, dans laquelle la partie réfractive (380) a un motif en forme de prisme comprenant une pluralité de couches ayant des sillons dans différentes directions.

6.  Cellule solaire à transmission sélective de la lumière (100, 200) de la revendication 3, dans laquelle la partie réfractive (380) a une pluralité de motifs tétraédriques ayant des sommets faisant saillie verticalement vers le haut à partir du substrat supérieur (110).

7.  Cellule solaire à transmission sélective de la lumière (100, 200) de la revendication 3, dans laquelle la lumière ayant traversé la partie réfractive (380) entre dans l'électrode supérieure (120) selon un angle allant de 1° à 35° par rapport à un axe perpendiculaire à l'électrode supérieure (120).

8.  Cellule solaire à transmission sélective de la lumière (100, 200) de la revendication 1, dans laquelle l'électrode inférieure (150) a une transmissivité de lumière pour transmettre la lumière du soleil d'une longueur d'onde transmise depuis la couche d'absorption de lumière (130) et la transférer dans une direction descendante.

9.  Cellule solaire à transmission sélective de la lumière (100, 200) de la revendication 1, dans laquelle le colorant (132) est un matériau pour transmettre la lumière du soleil ayant une longueur d'onde dans une plage allant de 400 à 500 nm.

10. Cellule solaire à transmission sélective de la lumière (100, 200) de la revendication 1, dans laquelle le colorant (132) est un matériau pour transmettre la lumière du soleil ayant une longueur d'onde dans une plage allant de 600 à 700 nm.

# FIG. 1

FIG. 2

FIG. 3

FIG. 4

FIG. 5

# FIG. 6

# FIG. 7

# FIG. 8

# FIG. 9

(A)

280

200

$\lambda o$

(B)

280

$\theta$

$\lambda c$

# FIG. 10

FIG. 11

# FIG. 12

(A)

(B)

(C)

FIG. 13

# FIG. 14